# EUROPÄISCHE PATENTANMELDUNG

(11) **EP 2 136 134 A2**
(43) Veröffentlichungstag der Anmeldung: **23.12.2009**
(21) Anmeldenummer: 08105820.8
(22) Anmeldetag: 19.11.2008
(51) Int. Cl.: F21V 9/14, G02B 5/30, G02B 27/28, F21S 8/12

(54) **Beleuchtungseinrichtung zum Aussenden von zumindest teilweise polarisiertem Licht**

(30) Priorität: 20.06.2008 DE 102008002555
(71) Anmelder: ROBERT BOSCH GMBH, 70442 Stuttgart (DE)
(72) Erfinder: Schmack, Andreas, 71229 Leonberg (DE); Franz, Gerald, 71522 Backnang (DE)

(57) **Zusammenfassung**

Die Erfindung betrifft eine Beleuchtungseinrichtung zum Aussenden von polarisiertem Licht, die aufweist:
eine Lichtquelle (1a) zum Aussenden von Licht (20) in mehr als einer Polarisationsebene, insbesondere im infraroten, sichtbaren oder ultravioletten Spektralbereich,
ein Polarisationsfilter (2a), das einfallendes Licht in Abhängigkeit von dessen Polarisation durchlässt oder reflektiert,
ein optisch aktives Mittel (3a) zum Drehen der Polarisationsebene des Lichtes, und
eine Reflektionseinrichtung (4a) zum Reflektieren des Lichts,

wobei die Lichtquelle, das Polarisationsfilter, das optisch aktive Mittel und die Reflektionseinrichtung (4a) in einem gemeinsamen Strahlengang derart angeordnet sind, dass
zumindest ein Teil des von der Lichtquelle (1a) abgestrahlten Lichtes (20-1) auf das Polarisationsfilter (2a) trifft,
zumindest ein Teil des von dem Polarisationsfilter (2a) reflektierten Teils (20-3) von der Reflektionseinrichtung (4a) zu dem Polarisationsfilter reflektiert wird,
wobei zumindest ein Teil des von dem Polarisationsfilter (2a) reflektierten Lichts (20-3) vor dem erneuten Auftreffen auf das Polarisationsfilter (2a) zumindest einmal auf das optisch aktive Mittel trifft.

## Beschreibung

### Stand der Technik

Für verschiedene Anwendungen, insbesondere im Bereich der Fahrzeugtechnik, werden Beleuchtungseinrichtungen verwendet, die polarisierte Strahlung bzw. polarisiertes Licht aussenden, insbesondere im Wellenlängenbereich des nahen und fernen Infrarots, aber auch im sichtbaren und im ultravioletten Bereich. So sind z. B. Nachtsichtsysteme für Fahrzeuge bekannt, die Scheinwerfer aufweisen, die polarisiertes Licht im nahen Infrarot aussenden. Um polarisiertes Licht zu erzeugen, ist es zum einen bekannt, als Lichtquelle der Beleuchtungseinrichtung einen Laser zu verwenden, der polarisiertes Licht aussendet, und zum anderen eine Lichtquelle, die unpolarisiertes Licht aussendet, in Kombination mit einem Polarisationsfilter zu verwenden.

Die Druckschrift EP 0 490 029 A2 offenbart ein Nachtsichtsystem, das eine als Scheinwerfer ausgebildete Beleuchtungseinrichtung zum Aussenden von polarisiertem Licht im nahen Infrarotbereich und eine Kamera zum Empfangen von Licht im Infrarotbereich aufweist. Die Kamera ermöglicht es, die vom Scheinwerfer ausgesandte und von Objekten der Umgebung reflektierte Strahlung zu detektieren und daraus ein Bild zu generieren. Die Kamera weist zusätzlich einen Polarisationsfilter auf. Durch geeignete Ausrichtung des Polarisationsfilters lässt sich die Überstrahlung bzw. Blendung des Bildsensors der Kamera durch entgegenkommende Fahrzeuge vermindern, die ebenfalls ein entsprechendes Nachtsichtsystem mit einem Scheinwerfer aufweisen, der polarisiertes Licht aussendet.

Die Druckschrift DE 100 27 018 A1 offenbart ein Nachtsichtsystem für ein Fahrzeug mit einer als Scheinwerfer ausgebildeten Beleuchtungseinrichtung mit einer Lichtquelle, wobei die Lichtquelle polarisiertes Licht im nahen Infrarot ausstrahlt. Die Beleuchtungseinrichtung weist ferner einen Polarisationsfilter auf, das geeignet polarisiertes Licht durchlässt. Des Weiteren ist ein Reflektor vorgesehen, der das von der Lichtquelle ausgesandte Licht bündelt.

Nachteilhaft bei der Verwendung eines Polarisationsfilters in einer derartigen Beleuchtungseinrichtung ist jedoch, dass der Lichtanteil, dessen Polarisationsebene nicht derjenigen des Polarisationsfilters entspricht, den Polarisationsfilters nicht passieren kann und somit bis zu 50 Prozent der Lichtleistung verloren geht.

### Offenbarung der Erfindung

Erfindungsgemäß sind ein reflektierendes Polarisationsfilter und ein optisch aktives Mittel im Strahlengang vorgesehen der Lichtquelle vorgesehen, die unpolarisierte Strahlung bzw. Strahlung mit mehr als einer Polarisationsebene aussendet. Hierbei reflektiert das Polarisationsfilter den nicht durchgelassenen Strahlungsanteil zurück, wobei dieser ganz oder teilweise wieder durch eine Reflektionseinrichtung zurück auf das Polarisationsfilter reflektiert wird und hierbei - vor und/oder nach der Reflektion durch die Reflektionseinrichtung - durch das optisch aktive Mittel in seiner Polarisation verändert wird. Hierbei kann insbesondere auch eine mehrfache Reflektion und Drehung der Polarisationsebene erfolgen.

Auf diese Weise kann ein Anteil des von der Lichtquelle ausgesandten Lichts, der aufgrund seiner Polarisationsebene das Polarisationsfilter nicht beim ersten Auftreffen passieren konnte, nachfolgend bei einem erneuten Auftreffen passieren. Die Intensität des von der Beleuchtungseinrichtung ausgesandten polarisierten Lichts lässt sich damit wesentlich erhöhen, so dass im Idealfall - abgesehen von nicht idealen Absorptionsverlusten im Polarisationsfilter und der Reflektionseinrichtung - eine nahezu vollständige Ausbeute der Lichtintensität erreichen lässt.

Als Lichtquelle eignet sich insbesondere eine Lichtquelle, die unpolarisiertes Licht aussendet, beispielsweise eine LED, einschließlich einer LED mit mehreren Lichtpunkten, eine Gasentladungslampe oder eine Glühlampe. Das Polarisationsfilter ist vorzugsweise derart ausgebildet, dass es den Lichtanteil, den es nicht passieren lässt, möglichst gut reflektiert, bevorzugt mit einem Anteil von mindestens 50 Prozent; die Absorption ist vorteilhafter Weise gering.

Hierbei sind Ausbildungen mit unterschiedlichen Anordnungen und Formgebungen der Reflektionseinrichtung möglich. Die Anordnung des optisch aktiven Mittels im Strahlengang kann so erfolgen, dass bereits das von der Lichtquelle ausgesandte Licht hindurch tritt, oder auch erst das von dem Polarisationsfilter und/oder der Reflektionseinrichtung reflektierte Licht.

Bei einer Ausführungsform kann z. B. auf im wesentlichen eine einmalige Reflektion an der Reflektionseinrichtung abgestellt werden, indem diese und die Lichtquelle gegenüber der optischen Achse versetzt angeordnet sind und somit das von dem Polarisationsfilter zurück reflektierte Licht im wesentlichen vollständig auf einen Reflektor fällt, der nachfolgend diese Strahlung im wesentlichen vollständig zu dem Polarisationsfilter zurück spiegelt, wobei das so zurückreflektierte Licht insgesamt eine Polarisationsdrehung von 180° (entsprechend λ/2) gegenüber dem direkt auf das Polarisationsfilter gelangende Licht aufweist. Weiterhin sind Ausbildungen mit anderen Reflektionseinrichtungen wie z. B. einer Ulbricht-Kugel möglich.

Der Drehwinkel des optisch aktiven Mittels wird vorteilhafterweise in Abhängigkeit davon gewählt, wie oft das reflektierte Licht zusätzlich hindurch gelangt, d.h. in Abhängigkeit von der Anordnung im Strahlengang.

Die erfindungsgemäße Beleuchtungseinrichtung kann grundsätzlich für beliebige Anwendungen vorgesehen sein. So kann sie in einer Bauform ausgebildet sein, die einer handelsüblichen Bauform ihrer Lichtquelle, insbesondere einer LED, einer Glühlampe (einschließlich Halogenlampe) oder einer Gasentladungslampe entspricht. Hierbei können das optisch aktive Mittel und der reflektierende Polarisationsfilter in den Aufbau des jeweiligen Leuchtmittels bzw. Beleuchtungseinrichtung integriert werden.

So werden bei handelsüblichen LEDs die Halbleiterelemente in eine Reflektorwanne gesetzt und in transparenten Kunststoffkörper eingegossen; erfindungsgemäß kann die Reflektorwanne direkt als Reflektor verwendet werden, ein reflektierendes Polarisationsfilter z. B. auf der Außenseite des Kunststoffkörpers ausgebildet und das optisch aktive Mittel z. B. in den Kunststoffkörper als Zusatz bzw. Dotierung eingebracht oder auf der Außenseite oder einer Innenseite als Schicht aufgetragen werden. Bei Glühlampen und Gasentladungslampen kann ein entsprechender Reflektor vorgesehen, auf einer Außenseite der Polarisationsfilter ausgebildet und das optisch aktive Mittel in einer Gasladung oder als Schicht ausgebildet werden.

Eine besondere Ausführungsform der erfindungsgemäßen Beleuchtungseinrichtung ist der Einsatz als Bestandteil eines Scheinwerfers für ein Fahrzeug oder direkt als Scheinwerfer, insbesondere für einen Scheinwerfer als Bestandteil eines Nachtsichtsystems, z. B. im IR- oder sichtbaren Bereich, das zusätzlich eine Kamera mit einem Bildsensor und einem Polarisationsfilter umfasst.

Alle Komponenten der erfindungsgemäßen Beleuchtungseinrichtung können somit als diskrete, mechanische Elemente ausgeführt werden, oder aber mit anderen Komponenten kombiniert oder in diese integriert werden, z. B. in Form einer Beschichtung bzw. durch die Wahl der Materialzusammensetzung.

### Kurze Beschreibung der Zeichnungen

Die Erfindung wird im Folgenden anhand von Ausführungsbeispielen, die durch mehrere Figuren dargestellt werden, näher erläutert. Es zeigt:
- Fig. 1: eine erste Ausführungsform einer erfindungsgemäßen Beleuchtungseinrichtung,
- Fig. 2: eine zweite Ausführungsform einer erfindungsgemäßen Beleuchtungseinrichtung, und
- Fig. 3: eine dritte Ausführungsform einer erfindungsgemäßen Beleuchtungseinrichtung;
- Fig. 4: ein erfindungsgemäßes Nachtsichtsystem mit der erfindungsgemäßen Beleuchtungsanordnung;
- Fig. 5: ein Fahrzeug mit dem erfindungsgemäßen Nachtsichtsystem;
- Fig. 6: eine erfindungsgemäße Beleuchtungseinrichtung in der Bauform einer LED;
- Fig. 7: eine erfindungsgemäße Beleuchtungseinrichtung in der Bauform einer Glühlampe;
- Fig. 8: eine erfindungsgemäße Beleuchtungseinrichtung in der Bauform einer Gasentladungslampe.

### Ausführungsformen der Erfindung

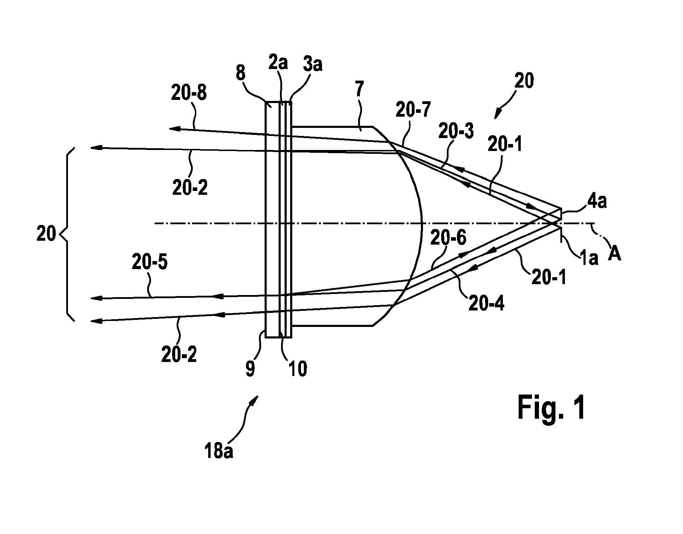

Figur 1 zeigt eine erste Ausführungsform einer erfindungsgemäßen Beleuchtungseinrichtung 18a. Die Beleuchtungseinrichtung 18a umfasst eine Lichtquelle, hier eine LED 1a, einen hier einteiligen Reflektor 4a, ein Polarisationsfilter 2a, ein optisch aktives Mittel zum Drehen der Polarisationsebene von Licht, hier als optisch aktive Schicht 3a, eine konkav, z. B. konkav-planar oder konkav-konvex gekrümmte Linse 7 aus z. B. Polycarbonat, sowie ein Glassubstrat 8. Das Glassubstrat 8 ist als Platte mit planparalleler Ober- und Unterseite 9, 10 ausgebildet. Auf der Unterseite 10 des Glassubstrats 8 ist das Polarisationsfilter 2a und nachfolgend die optisch aktive Schicht 3a in Form planparalleler Schichten durch Beschichtung ausgebildet. Die LED 1a ist derart angeordnet, dass diese der optisch aktiven Schicht 3a zugewandt ist, und das Polarisationsfilter 2a und das Glassubstrat 8 hinter der optisch aktiven Schicht 3a liegen. Die Linse 7 ist zwischen LED 1a und optisch aktiver Schicht 3a angeordnet, z. B. beabstandet zur optisch aktiven Schicht 3a oder an dieser anliegend. Der Reflektor 4a ist als planparallele Platte ausgebildet und zur LED 1a seitlich beabstandet.

Die LED 1a emittiert Licht 20 bzw. Strahlung 20 z. B. im nahen Infrarot. Das Polarisationsfilter 2a ist derart ausgebildet, dass es zumindest im Spektralbereich der LED 1a den Lichtanteil des Lichts 20, dessen Polarisation von der Polarisationsebene des Polarisationsfilters 2a abweicht, weitgehend reflektiert, z. B. mit einem Anteil von mindestens 50 Prozent. Die optisch aktive Schicht 3a ist derart ausgebildet, dass diese die Polarisationsebene des Lichts zumindest im genannten Spektralbereich beim Hindurchtreten um 45° dreht; sie kann z. B. als λ/4-Schicht ausgebildet sein. Das Glassubstrat 8 mit dem Polarisationsfilter 2a und der optisch aktiven Schicht 3a ist z. B. bezüglich der optischen Achse A der Linse 7 leicht verkippt.

Nachfolgend wird der Strahlengang des beispielhaft gezeigten Lichtstrahls 20-1 beschrieben. Das von der LED 1a emittierte, unpolarisierte Licht 20-1 wird zunächst von der Linse 7 gebündelt, tritt dann durch die optisch aktive Schicht 3a hindurch, wodurch seine Polarisationsebene um 45° gedreht wird, und trifft dann auf das Polarisationsfilter 2a. Der Lichtanteil 20-2 des Lichts 20-1, dessen Polarisationsebene der dem Polarisationsfilter 2a zugeordneten Polarisationsebene entspricht, passiert das Polarisationsfilter 2a. Der Lichtanteil 20-3 des Lichts 20-1, der aufgrund seiner Polarisationsebene nicht das Filter 2a passieren kann, wird überwiegend reflektiert, tritt nachfolgend wieder durch die optisch aktive Schicht 3a hindurch, wodurch seine Polarisationsebene um 45° gedreht wird, wird danach durch die Linse 7 gebündelt und trifft, da das Polarisationsfilter 2a verkippt angeordnet ist, auf den bezüglich der LED 1 a versetzten Reflektor 4a. Der Reflektor 4a reflektiert diesen Lichtanteil 20-3 als Lichtstrahl 20-4, der erneut durch die Linse 7 hindurch tritt und auf die optisch aktive Schicht 3a trifft. Hier wird der Lichtanteil erneut um 45° gedreht, so dass dieser Lichtanteil 20-4 gegenüber dem Licht 20-2 um insgesamt 90° gedreht ist. Von diesem Lichtanteil 20-4 passiert nun der Anteil 20-5 das Polarisationsfilter 2a.

Bei dieser Ausführungsform kann bereits die einmalige Reflexion am Reflektor 4a ausreichend sein. Bei dieser Ausführungsform, insbesondere aber auch bei einer optisch aktiven Schicht 3a mit einer Drehung um einen anderen Winkel als 45° kann jedoch auch eine Mehrfachreflexion erfolgen, so dass von dem Lichtanteil 20-4 der Anteil 20-6, der nicht durch das Polarisationsfilter 3a gelangt, wieder zum Reflektor 4a reflektiert wird und als Licht 20-7 erneut auf das Polarisationsfilter 2a trifft, wobei es zweimal die optisch aktive Schicht 3a passiert hat, usw. Somit kann - bei hinreichend geringer Absorption am Polarisationsfilter 2a und Reflektor 4a, die Lichtausbeute weiter erhöht werden.

Die Intensität des Lichts, die die erfindungsgemäße Beleuchtungseinrichtung 18a aussendet, ist somit erfindungsgemäß gegenüber einer Beleuchtungseinrichtung, bei der der vom Filter reflektierte und/oder absorbierte Lichtanteil vollständig verloren geht, deutlich erhöht.

Als eine Alternative zur Verkippung des Filters 2a und/oder der optisch aktiven Schicht 3a zur optischen Achse A kann das Filter und/oder die optisch aktive Schicht keilförmig ausgeführt werden. Weiterhin können auch wie eingezeichnet die LED 1 a und der Reflektor 4a symmetrisch zur optischen Achse A versetzt sein; relevant ist, dass eine weitgehende Erfassung der Lichtanteile 20-1, 20-3,... erfolgt.

Als Variante kann die optisch aktive Schicht auch in den Reflektor 4a integriert werden, insbesondere in Form einer Beschichtung.

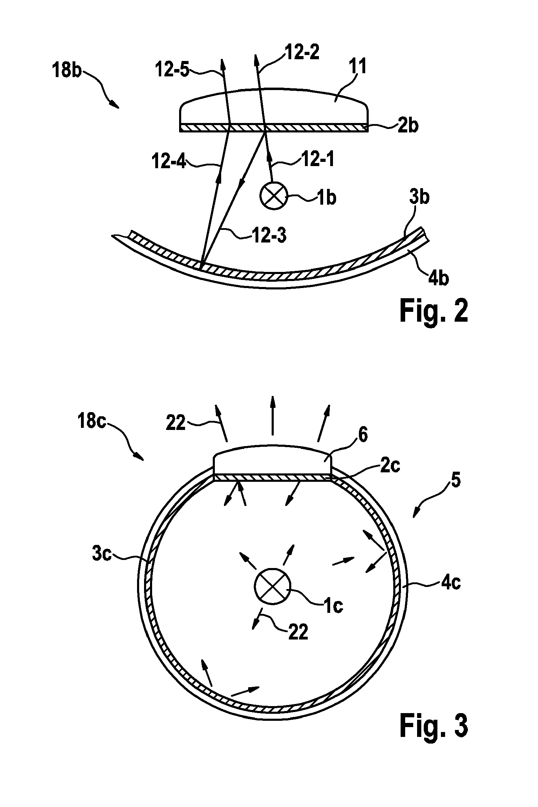

In einer weiteren Variante kann das Polarisationsfilter 2a und die optisch aktive Schicht 3a zwischen Linse 7 und LED 1a angeordnet werden. Der Reflektor 4a kann derart ausgebildet sein, dass er den rückseitigen Bereich der LED 1a abdeckt, entsprechend wie bei Figur 2.

In einer weiteren Variante kann das Polarisationsfilter 2a und/oder die optisch aktive Schicht 3a direkt auf der Oberfläche der Linse 7 aufgebracht sein.

In einer weiteren Variante kann das Polarisationsfilter 2a derart angeordnet oder derart ausgeprägt sein, dass das von diesem reflektierte Licht wieder auf die LED 1 a trifft. Die LED 1 a kann dadurch zur zusätzlichen Emission angeregt werden. Der Reflektor 4a ist dann geeignet hinter der LED 1 a angeordnet.

In einer Ausbildung dieser Variante kann ein Kunststoff, in den die LED eingegossen ist, mit einer optisch aktiven Substanz, durch die eine Drehung der Polarisationsebene bewirkt wird, angereichert werden. Die optisch aktive Schicht 3a wäre in diesem Fall in diese Kunststoffumhüllung integriert. Falls alternativ zu einer LED eine Glüh- oder Gasentladungslampe verwendet wird, kann eine optisch aktive Gasfüllung verwendet werden. Die Komponenten können auch derart angeordnet sein, dass der vom Polarisationsfilter reflektierte Anteil zumindest teilweise auf die Gasentladungslampe zurückgeworfen wird, was eine zusätzliche Emission von Strahlung anregen kann.

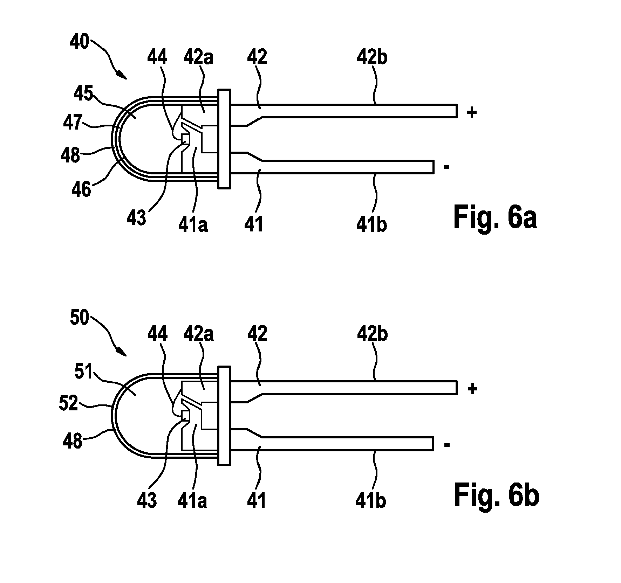

Die erfindungsgemäße Beleuchtungseinrichtung kann insbesondere auch in der üblichen Bauform der jeweiligen Lichtquelle ausgebildet sein. Fig. 6a und 6b zeigen hierzu Ausführungsformen von Beleuchtungseinrichtungen 40 und 50, die die Bauform einer LED aufweisen. Hierbei ist jeweils eine Kathode 41 in ihrem linken Bereich als Reflektorwanne 41a und ihrem rechten Bereich als Anschlusskontakt 41b bzw. Anschlussstift ausgebildet, wobei in der Reflektorwanne 41a ein Halbleiterelement 43 aufgenommen und hierdurch kontaktiert ist. Weiterhin ist eine Anode 42 vorgesehen, deren rechter Bereich 42b als Anschlusskontakt bzw. -stift und deren linker Bereich 42a über einen Drahtbond 44 mit dem Halbleiterelement 43 kontaktiert ist. Die Reflektorwanne 41a, der Bereich 42b, das Halbleiterelement 43 und der Drahtbond 44 sind in einen Kunststoffkörper 45 oder 45a eingegossen ist, der als mechanischer Schutz sowie als Linse dient, die im allgemeinen mit einem konvexen Bereich ausgebildet ist und somit eine direkt an das Halbleiterelement 43 angrenzende, im wesentlichen plan-konvexe Linse ausbildet.

Erfindungsgemäß wird erkannt, dass bei dieser typischen Bauform einer LED mit relativ geringem zusätzlichem Aufwand eine erfindungsgemäße Beleuchtungseinrichtung 40 oder 50 nach Fig. 6a, 6b ausgebildet werden kann.

In der Beleuchtungseinrichtung 40 der Fig. 6a ist hierzu auf der Oberseite 46 des Kunststoffkörpers 45 eine optisch aktive Schicht 47 entsprechend der Schicht 3a der Fig. 1, und auf dieser ein reflektierendes Polarisationsfilter 48 entsprechend der Schicht 2a der Fig. 1 aufgetragen. Die Reflektorwanne 41 a entspricht somit dem Reflektor 4a der Fig. 1.

In der Beleuchtungseinrichtung 50 der Fig. 6b ist der Kunststoffkörper 51 bereits mit einem optisch aktiven Mittel versehen und lediglich das reflektierende Polarisationsfilter 48 auf seiner Oberfläche 52 aufgetragen.

Die Beleuchtungseinrichtungen 40 und 50 sind somit gleich groß wie herkömmliche LEDs bei gleicher Bauform bzw. Aufbau, senden jedoch auch bei einem unpolarisiert strahlenden Halbleiterelement 43 polarisiertes Licht.

Bei Glühlampen, insbesondere Halogenlampen, die einen Glaskolben aufweisen, kann das Polarisationsfilter und/oder die optisch aktive Schicht als Beschichtung direkt auf dem Glaskolben ausgebildet sein. Vorzugsweise kann das Polarisationsfilter in dem Bereich des Glaskolbens ausgebildet werden, indem die Glühlampe für die Strahlung durchlässig ist.

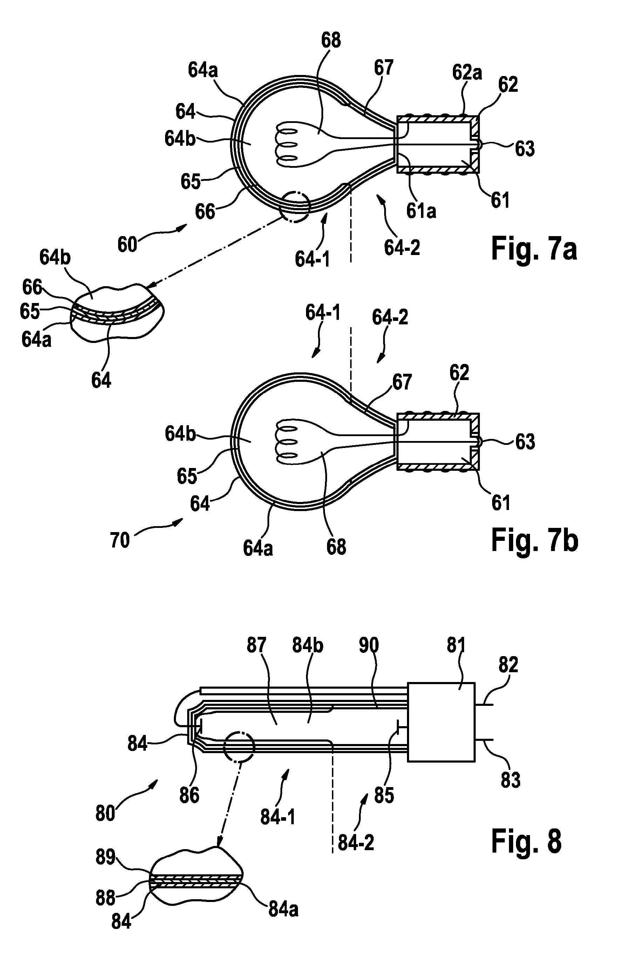

Fig. 7a und 7b zeigen hierzu Ausführungsformen einer Beleuchtungseinrichtung 60 und 70 in der Bauform bzw. Aufbau einer herkömmlichen Glühbirne, wobei mit entsprechender Formgebung auch eine Halogenlampe ausgebildet wird. Ein Sockel 61 weist zwei Elektroden 62 und 63 auf, in Fig. 6a und 6b entsprechend einer Glühbirne mit einer metallischen Fassung 62, z. B. mit Außengewinde 62a oder Bajonett, und der weiteren Elektrode 63; die Elektroden 62, 63 können auch als Steckstifte ausgebildet sein. Die Verwendung eines einzudrehenden Außengewindes kann gegebenenfalls zu Schwierigkeiten bei der Ausrichtung der Polarisationsebene führen, so dass hier Steckstifte vorteilhaft sein können. An dem Sockel 62 ist ein Glaskolben 64 angebracht, in dessen Innenraum 64b ein Schutzgas, z. B. mit Unterdruck, aufgenommen ist, in den sich die mit den Elektroden 62, 63 kontaktierte Glühwendel 68 erstreckt. In Fig. 6 a ist auf der Innenseite 64a des Glaskolbens 64 ein reflektierendes Polarisationsfilter 65 als Schicht entsprechend der Schicht 2a der Fig. 1 aufgebracht, auf dem Polarisationsfilter 65 - d.h. zum Innenraum des Glaskolbens 64 hin - eine optisch aktive Schicht 66, d.h. ein Aufbau entsprechend Fig. 1, wobei die Schichten 65, 66 insbesondere in einem vorderen Bereich 64-1 aufgetragen sind. Der Reflektor wird hierbei z. B. durch die verspiegelte, plane Oberseite 61 a des Sockels 61, vorzugsweise weiterhin durch eine Reflexionsschicht 67 im hinteren, an den Sockel 61 angrenzenden Bereich 64-2 ausgebildet. In Fig. 7a und 7b sind hierbei gestrichelte Linien als Trennlinien zwischen den Bereichen 64-1 und 64-2 eingezeichnet. Das Schutzgas im Innenraum 64b kann entsprechend einer Glühbirne chemisch inert und entsprechend einer Halogenlampe ein Halogen sein bzw. enthalten. In Fig. 7b ist lediglich das Polarisationsfilter 65 als Schicht aufgetragen, und ein optisch aktive Gas im Innenraum 64b als Teil eines Gasgemisches aufgenommen.

Bei den Ausführungsformen der Fig. 7 a und b können die Schichten 65 bzw. 65 und 66 auch auf der Außenseite des Glaskolbens 64 oder auf der Außen- und Innenseite ausgebildet sein, wobei die Schicht 65 jeweils die äußere und die Schicht 66 die innere Schicht ist.

Ebenfalls als Lichtquelle 1a eignet sich auch ein Kaltlicht. Die erfindungsgemäße Beleuchtungseinrichtung 18a der Fig. 1 kann insbesondere in Form einer Kaltlicht-Reflektor-Lampe ausgebildet werden. Eine derartige Lampe ist typischerweise so aufgebaut, dass das Leuchtmittel selber im Brennpunkt eines Reflektors sitzt. Der das Leuchtmittel umgebende Reflektor ist mit einer Glasscheibe verschlossen. Ein Polarisationsfilter und ein optisch aktives Mittel lassen sich beispielsweise auf der Innen- oder Außenseite dieser Glasscheibe aufbringen. Der Reflektor oder eine zusätzliche Fläche im Strahlengang der Lichtquelle sind vorzugsweise so ausgebildet, dass sie die Polarisation zumindest der beim ersten Auftreffen auf das Polarisationsfilter zurückreflektierte Licht um vorzugsweise 90 Grad drehen.

Fig. 8 zeigt eine erfindungsgemäße Ausbildung als einer Beleuchtungseinrichtung 80 als Gasentladungslampe mit herkömmlicher Bauform, die einen Sockel 81 mit Steuergerät einschließlich Startelektronik und zwei Anschlussstiften 82, 83 sowie einen Glaskolben 84 aufweist, in dessen Innenraum 84b zwei Elektroden 85, 86 hineinragen, zwischen denen in bekannter Weise eine Gasentladung bzw. Lichtbogen gezündet wird. Der Aufbau entspricht im wesentlichen dem der Fig. 7a oder 7b, d.h. der Glaskolben 84 kann mit einem vorderen Bereich 84-1 und einem an den Sockel 81 angrenzenden hinteren Bereich 84-2 ausgebildet sein, wobei er im Bereich 84-1 an der Innenseite 84a mit zumindest dem Polarisationsfilter 88 beschichtet ist, wobei entsprechend Fig. 7a auf dem Polarisationsfilter 88 eine optisch aktive Schicht 89 aufgetragen sein kann oder entsprechend Fig. 7b in der Gasfüllung des Innenraums 84b ein optisch aktives Mittel enthalten sein kann. Auch in Fig. 8 ist eine gestrichelte Trennlinie zur Verdeutlichung der Bereiche 84-1 und 84-2 eingezeichnet. Im hinteren Bereich 84-2 kann an der Innenseite 84a eine Reflexionsschicht 90 z. B. als Metallschicht aufgedampft sein. Auch in Fig. 8 können die Schichten 88, 89 an der Innen- und/oder Außenseite des Glaskolbens 84 ausgebildet sein.

Figur 2 zeigt eine zweite Ausführungsform einer erfindungsgemäßen Beleuchtungseinrichtung 18b. Die Beleuchtungseinrichtung 18b ist hier als Scheinwerfer eines Fahrzeugs ausgebildet. Der Scheinwerfer umfasst eine Lichtquelle, hier eine Gasentladungslampe 1b, ein Polarisationsfilter 2b, ein optisch aktives Mittel zum Drehen der Polarisationsebene von Licht, hier eine optisch aktive Schicht 3b, einen Reflektor 4b und ein Glaselement 11, das als Frontglas 11 des Scheinwerfers ausgebildet ist. Das Polarisationsfilter 2b ist als Beschichtung auf der der Gasentladungslampe 1 b zugewandten planen Rückseite des Frontglases 11 angeordnet. Der Reflektor 4b ist konkav geformt, wobei sich die Gasentladungslampe 1 b im Innenbereich befindet. Auf der reflektierenden Innenfläche des Reflektors 4b ist in Form einer Beschichtung die optisch aktive Schicht 3b aufgetragen. Die optisch aktive Schicht 3b ist dabei derart ausgebildet, dass die Polarisationsebene von Licht, das von einer Seite zur anderen Seite der optisch aktiven Schicht 3b hindurch tritt, um 45° gedreht wird. Der Reflektor 4b ist derart ausgebildet, dass Einfallswinkel und Reflektionswinkel bezogen auf das Einfallslot gleich sind.

Von der Gasentladungslampe 1b wird Licht 12-1 emittiert, hiervon gelangt der Anteil 12-2 durch das Filter 2b, ein weiterer Anteil 12-3 wird reflektiert. Der reflektierte Anteil 12-3 tritt durch die optisch aktive Schicht 3b hindurch, wird am Reflektor 4b reflektiert und tritt als Licht bzw. Lichtstrahl 12-4 wieder durch die optisch aktive Schicht 3b hindurch, und kann nun das Filter 2b als Lichtstrahl 12-5 passieren, da seine Polarisationsebene um 90° gedreht wurde.

In einer Variante ist das Polarisationsfilter 2b leicht gekippt zur Strahlachse Gasentladungslampe 1b - Polarisationsfilter 2b. Alternativ kann das Polarisationsfilter keilförmig ausgebildet sein. Die optisch aktive Schicht 3b kann in einer Variante auf das Polarisationsfilter 2b aufgebracht sein.

Auch die Ausführungsform der Fig. 2 kann in einer Bauform eines herkömmlichen Leuchtmittels entsprechend Fig. 6a, b Fig. 7a, b oder Fig. 8 ausgebildet sein, indem z. B. in Fig. 6a die optisch aktive Schicht 46 auf der Reflektorwanne 41 a aufgetragen ist und in Fig. 7a, 8 a entsprechend die optisch aktive Schicht 66 bzw. 89 auf der Reflektorschicht 67 oder 90.

Figur 3 zeigt eine weitere Ausführungsform einer erfindungsgemäßen Beleuchtungseinrichtung 18c, z. B. ebenfalls ausgebildet als Scheinwerfer 18c eines Fahrzeugs. Der Scheinwerfer 18c umfasst eine Lichtquelle, hier eine Gasentladungslampe 1c, ein Polarisationsfilter 2c, ein optisch aktives Mittel zum Drehen der Polarisationsebene von Licht 22, hier eine optisch aktive Schicht 3c, eine Ulbricht-Kugel 5, deren Innenfläche als Reflektor 4c ausgebildet ist, vorzugsweise ein diffus streuender, sehr gering absorbierender Reflektor 4c, z. B. aus Bariumsulfat, und eine Glasscheibe 6, die als Frontglas des Scheinwerfers ausgebildet ist.

Die Glasscheibe 6 verschließt eine Öffnung der Ulbricht-Kugel 5. Das Filter 2c ist auf der Rückseite der Glasscheibe 6, die ins Innere der Ulbricht-Kugel 5 gerichtet ist, in Form einer Beschichtung angeordnet. Die Gasentladungslampe 1c befindet sich im Zentrum der Ulbricht-Kugel 5. Die optisch aktive Schicht 3c bedeckt die reflektierende Innenfläche 4c der Ulbricht-Kugel 5. Die reflektierende Innenfläche 4c ist dabei derart ausgebildet, dass einfallende Strahlung diffus reflektiert wird. Die optisch aktive Schicht 3c ist derart ausgebildet, dass von einer Seite zur anderen Seite hindurch tretendes Licht 22 um 15° gedreht wird. Hier sind allerdings auch beliebige andere Winkel möglich.

Der Einsatz einer Ulbricht-Kugel bietet den Vorteil, dass das von der Gasentladungslampe 1b ausgesandte Licht 22 bzw. Strahlung vielfach reflektiert und ideal durchmischt wird. Der Polarisationsfilter 2c an der Öffnung der Ulbricht-Kugel 5 verhindert, dass falsch polarisierte Strahlung die Kugel verlässt. Werden Verluste durch Absorption minimiert, so kann gewährleistet werden, dass ein Großteil des von der Gasentladungslampe 1b abgestrahlten Lichts 22 nach Verlassen des Scheinwerfers polarisiert ist.

Als Variante kann das optisch aktive Mittel 3c als diskretes Element, beispielsweise als Platte, direkt vor den Polarisationsfilter 2c angeordnet werden, als Schicht auf das Polarisationsfilter 2c aufgetragen oder in die diffus reflektierende Innenfläche 4c der Ulbricht-Kugel integriert werden. Werden Ulbrichtkugeln verwendet, die so genannte Shutter aufweisen, die den direkten Weg des Lichts von der Eintritts- in die Austrittsöffnung versperren, kann das optisch aktive Mittel vorteilhaft im Rahmen eines derartigen Shutters integriert werden.

Da der Lichtweg in einer Ulbrichtkugel 5 nicht vorher bestimmt ist, ist es nicht notwendig, dass die optisch aktive Schicht 3c eine Drehung um einen bestimmten Winkel durchführt. Vielmehr kann das Licht 22 auch mehrfach vom Polarisationsfilter 2c zurückgewiesen, erneut um einen Winkel gedreht und dann über den Reflexionsweg wieder zum Filter 3c zurückkehren.

Alternativ zu einer Gasentladungslampe kann insbesondere auch eine LED eingesetzt werden. Diese hat den Vorteil, dass sie nur sehr schmalbandig emittiert. Beteiligte optische Komponenten könnten aufgrund dessen kostengünstiger ausgewählt werden.

Weiterhin kann das optisch aktive Element in dieser und den anderen Ausführungsformen auch als separates Element, z. B. Scheibe, insbesondere λ/4-Scheibe im Strahlengang vorgesehen sein.

Als optisch aktives Mittel eignet sich in allen Ausführungsformen beispielsweise Polyphenylenamin, das sich insbesondere auch als Beschichtung auftragen lässt, oder chirale Polyaneline.

Die als Leuchtmittel ausgebildeten Beleuchtungseinrichtungen 40, 50, 60, 70, 80 der Figuren 6a,b, 7a,b und 8 lassen sich - neben beliebigen anderen Verwendungen - auch wie herkömmliche Leuchtmittel in einem Scheinwerfer eines Fahrzeuges einsetzen, z. B. in einem Nachtsichtsystem, wobei allerdings die Polarisationsrichtung beim Einsetzen der Beleuchtungseinrichtungen 40, 50, 60, 70, 80 zu berücksichtigen ist, damit sie auf den Polarisationsfilter der Kamera abgestimmt ist.

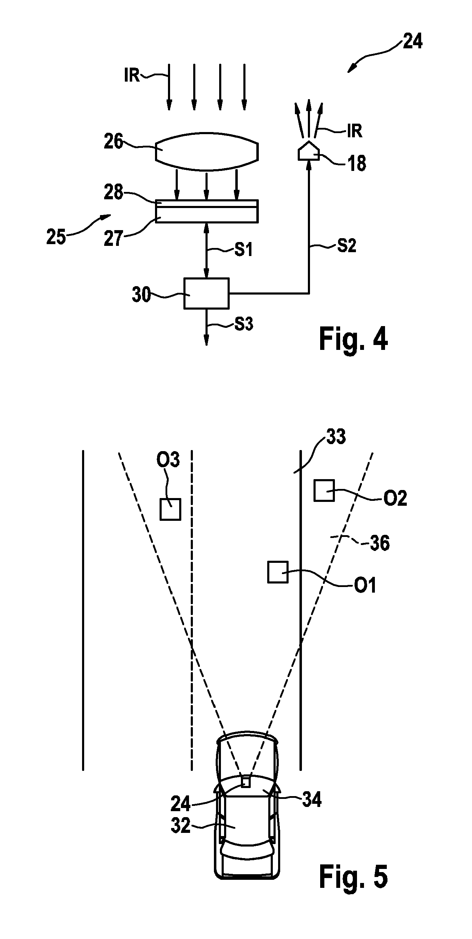

Alternativ hierzu können erfindungsgemäß die Beleuchtungseinrichtungen 18a, 18b, 18c gemäß den Figuren 1, 2, 3 auch direkt als Scheinwerfer eines Fahrzeugs ausgebildet werden, der insbesondere Teil eines Nachtsichtsystems ist. Fig. 4 zeigt ein Nachtsichtsystem 24, das eine Beleuchtungseinrichtung 18 zum Aussenden von IR-Strahlung IR, weiterhin eine Kamera 25 mit z. B. einer Projektionsoptik 26, einem Bildsensor 27 und einem Polarisationsfilter 28 zum selektiven Ausfiltern polarisierter IR-Strahlung aufweist, wobei das Polarisationsfilter 28 vor dem Bildsensor 27 angeordnet ist. Die Beleuchtungseinrichtung 18 kann z. B. als Ausführungsform 18a, 18b, 18c der Fig. 1 bis 3 ausgebildet sein, die IR-Strahlung 20, 12 oder 22 aussendet. Die verwendeten optischen Komponenten sind entsprechend auf den gewünschten Wellenlängenbereich abgestimmt, z. B. das nahe Infrarot. Der Bildsensor 27 kann insbesondere ein CMOS- oder CCD-Bildsensor 27 mit einem Pixel-Array als Imager zur Ausgabe eines Bildsignals S1 an eine Steuereinrichtung 30 sein, die durch Steuersignale S2 die Beleuchtungseinrichtung 18 ansteuert und fahrzeugintern Signale S3 weitergibt.

Fig. 5 zeigt ein Fahrzeug 32 auf einer Fahrbahn 33 mit dem Nachtsichtsystem 24 hinter seiner Windschutzscheibe 34, das in seinem Erfassungswinkel 36 Objekte 01, 02, 03 erfasst.

## Patentansprüche

1. Beleuchtungseinrichtung zum Aussenden von zumindest teilweise polarisiertem Licht, die aufweist:
eine Lichtquelle (1a, 1b, 1c) zum Aussenden von Licht (20, 12, 22) in mehr als einer Polarisationsebene, insbesondere im infraroten, sichtbaren oder ultravioletten Spektralbereich,
ein Polarisationsfilter (2a, 2b, 2c), das einfallendes Licht (20, 12, 22) in Abhängigkeit von dessen Polarisation durchlässt oder reflektiert,
ein optisch aktives Mittel (3a, 3b, 3c) zum Drehen der Polarisationsebene des Lichtes (20, 12, 22), und
eine Reflektionseinrichtung (4a, 4b, 4c) zum Reflektieren des Lichts (20),
wobei die Lichtquelle (1a, 1b, 1c), das Polarisationsfilter (2a, 2b, 2c), das optisch aktive Mittel (3a, 3b, 3c) und die Reflektionseinrichtung (4a, 4b, 4c) in einem gemeinsamen Strahlengang derart angeordnet sind, dass
zumindest ein Teil des von der Lichtquelle (1a, 1b, 1c) abgestrahlten Lichtes (20-1, 12-1, 22) direkt oder indirekt auf das Polarisationsfilter (2a, 2b, 2c) trifft,
zumindest ein Teil des von dem Polarisationsfilter (2a, 2b, 2c) reflektierten Lichtes (20-3, 12-3, 22) auf die Reflektionseinrichtung (4a, 4b, 4c) trifft und zumindest teilweise zu dem Polarisationsfilter (2a, 2b, 2c) reflektiert wird, und
wobei zumindest ein Teil des von dem Polarisationsfilter (2a, 2b, 2c) reflektierten Lichts (20-3, 12-3, 22) vor dem erneuten Auftreffen auf das Polarisationsfilter (2a, 2b, 2c) zumindest einmal auf das optisch aktive Mittel (3a, 3b, 3c) trifft.

2. Beleuchtungseinrichtung nach Anspruch 1, **dadurch gekennzeichnet, dass** die Lichtquelle (1a, 1b, 1c) unpolarisiertes Licht (20, 12, 22) abstrahlt.

3. Beleuchtungseinrichtung nach einem der vorhergehenden Ansprüche, **dadurch gekennzeichnet, dass** das Polarisationsfilter (2a, 2b, 2c) das einfallende Licht im wesentlichen ohne Absorption entweder durchlässt oder reflektiert.

4. Beleuchtungseinrichtung nach Anspruch 3, **dadurch gekennzeichnet, dass** das Polarisationsfilter (2a, 2b, 2c) derart ausgebildet ist, dass es Licht (20-3, 12-3, 22), dessen Polarisation von der Polarisationsebene des Polarisationsfilters (2a, 2b, 2c) abweicht, mit einem Anteil von mindestens 50 Prozent reflektiert.

5. Beleuchtungseinrichtung nach einem der vorhergehenden Ansprüche, **dadurch gekennzeichnet, dass** zumindest ein Teil des vom Polarisationsfilter (2a, 2b, 2c) reflektierten Lichtes (20-3, 12-3, 22) vor dem erneuten Auftreffen auf das Polarisationsfilter (2a, 2b, 2c) genau zweimal auf das optisch aktive Mittel (3a, 3b, 3c) trifft.

6. Beleuchtungseinrichtung nach einem der vorhergehenden Ansprüche, **dadurch gekennzeichnet, dass** zumindest ein Teil des Lichtes (20, 12, 22) mehrmals auf das Polarisationsfilter (2a, 2b, 2c) trifft und von diesem reflektiert wird.

7. Beleuchtungseinrichtung nach einem der vorhergehenden Ansprüche, **dadurch gekennzeichnet, dass** das optisch aktive Mittel (3a, 3b) derart ausgebildet ist, dass es die Polarisationsebene des Lichts um etwa 45° dreht.

8. Beleuchtungseinrichtung nach einem der vorhergehenden Ansprüche, **dadurch gekennzeichnet, dass** die Reflektionseinrichtung (4a) versetzt zur Lichtquelle (1a) angeordnet ist, und das Polarisationsfilter (2a) und/oder das optisch aktive Mittel (3a) eine plane Oberfläche aufweist, die bezüglich einer optischen Achse A geneigt oder verkippt ist.

9. Beleuchtungseinrichtung nach einem der vorhergehenden Ansprüche, **dadurch gekennzeichnet, dass** das optisch aktive Mittel (3a) auf dem Polarisationsfilter (2a) ausgebildet ist, z. B. als Beschichtung.

10. Beleuchtungseinrichtung nach einem der Ansprüche 1 bis 7, **dadurch gekennzeichnet, dass** das optisch aktive Mittel (3b, 3c) auf der Reflektionseinrichtung (4b, 4c) ausgebildet ist, z. B. als Beschichtung.

11. Beleuchtungseinrichtung nach einem der vorhergehenden Ansprüche, **dadurch gekennzeichnet, dass** es eine Ulbrichtkugel (5) aufweist, wobei die Reflektionseinrichtung (4c) als Innenfläche der Ulbrichtkugel (5) ausgebildet ist, die Lichtquelle (1c) innerhalb der Ulbrichtkugel (5) angeordnet ist und das Polarisationsfilter (2c) an einem Ausgang (6) der Ulbrichtkugel (5) angeordnet ist.

12. Beleuchtungseinrichtung nach einem der Ansprüche 1 bis 10, **dadurch gekennzeichnet, dass**
sie als LED-Leuchtmittel (40, 50) ausgebildet ist und zwei Anschlussstifte (41b, 42b), eine mit einem Anschlussstift kontaktierte Reflektorwanne (41a), ein auf der Reflektorwanne (41a) aufgenommenes Halbleiterelement (43) und einen eine Linse bildenden Kunststoffkörper (45) aufweist, wobei die Reflektorwanne (41a) und das HalbleiterBauelement (43) in den Kunststoffkörper (45) aufgenommen sind,
wobei die Reflektionseinrichtung als die Reflektorwanne (41a) und die Lichtquelle als das Halbleiterelement (43) ausgebildet ist und das reflektierende Polarisationsfilter (48) als Schicht auf der Außenseite des Kunststoffkörpers (45) aufgetragen ist.

13. Beleuchtungseinrichtung nach Anspruch 12, **dadurch gekennzeichnet, dass** das optisch aktive Mittel (46) als Schicht zwischen der Außenseite des Kunststoffkörpers (45) und dem Polarisationsfilter (48) ausgebildet ist.

14. Beleuchtungseinrichtung nach Anspruch 12, **dadurch gekennzeichnet, dass** das optisch aktive Mittel in dem Kunststoffmaterial des Kunststoffkörpers (45) aufgenommen ist.

15. Beleuchtungseinrichtung nach einem der Ansprüche 1 bis 10, **dadurch gekennzeichnet, dass**
sie als Glühwendel-Leuchtmittel (60, 70) ausgebildet ist und aufweist:
einen Sockel (61) mit zwei Anschlusskontakten (62, 63) und
einen mit einem Schutzgas, z. B. Inertgas oder Halogengas, gefüllten Glaskolben (64),
wobei die Lichtquelle als eine in dem Glaskolben (64) aufgenommene, mit den Anschlusskontakten (62, 63) kontaktierte Glühwendel (68) ausgebildet ist,
wobei das Polarisationsfilter (65) als Schicht auf der Innenseite (64a) oder Außenseite des Glaskolbens (64) ausgebildet ist.

16. Beleuchtungseinrichtung nach Anspruch 15, **dadurch gekennzeichnet, dass** das optisch aktive Mittel als optisch aktive Schicht (66) auf der Innenseite (64a) oder Außenseite des Glaskolbens (64) ausgebildet ist, wobei die optisch aktive Schicht (66) innerhalb des Polarisationsfilters (65) ausgebildet ist.

17. Beleuchtungseinrichtung nach Anspruch 15, **dadurch gekennzeichnet, dass** das Polarisationsfilter (65) auf der Innenseite (64a) des Glaskolbens (64) und die optisch aktive Schicht (66) auf der Innenseite des Polarisationsfilters (65) ausgebildet ist.

18. Beleuchtungseinrichtung nach Anspruch 15, **dadurch gekennzeichnet, dass** das optisch aktive Mittel als Bestandteil der Gasfüllung des Innenraums (64b) des Glaskolbens (64) ausgebildet ist.

19. Beleuchtungseinrichtung nach einem der Ansprüche 1 bis 10, **dadurch gekennzeichnet, dass**
sie als Gasentladungs-Leuchtmittel (80) ausgebildet ist und aufweist:
einen Sockel (81) mit zwei Anschlusskontakten (82, 83) und
einen mit einem Schutzgas gefüllten Glaskolben (84), in dessen Innenraum (84b) zwei Elektroden (85, 86) angeordnet und zwischen den Elektroden (85, 86) ein Gasentladungsbereich (87) als die Lichtquelle ausgebildet ist,
wobei das Polarisationsfilter (88) als Schicht auf der Innenseite (64a) oder Außenseite des Glaskolbens (64) ausgebildet ist.

20. Beleuchtungseinrichtung nach Anspruch 19, **dadurch gekennzeichnet, dass** das Polarisationsfilter (88) auf der Innenseite (84a) des Glaskolbens (84) und die optisch aktive Schicht (89) auf der Innenseite des Polarisationsfilters (88) ausgebildet ist.

21. Beleuchtungseinrichtung nach Anspruch 19, **dadurch gekennzeichnet, dass** das optisch aktive Mittel als Bestandteil der Gasfüllung des Innenraums (84b) des Glaskolbens (84) ausgebildet ist.

22. Beleuchtungseinrichtung (18a, 18b, 18c) nach einem der Ansprüche 1 bis 11, **dadurch gekennzeichnet, dass** sie als Scheinwerfer für ein Fahrzeug (32) ausgebildet ist.

23. Nachtsichtsystem (24) für ein Fahrzeug (32), das als Scheinwerfer eine Beleuchtungseinrichtung (18a, 18b, 18c) nach Anspruch 22 und weiterhin eine Kamera (25) mit einem Bildsensor (27) und einem im Strahlengang vor dem Bildsensor (27) angeordneten Polarisationsfilter (28) aufweist, wobei der Bildsensor (27) und das Polarisationsfilter (28) abgestimmt sind auf den von der Beleuchtungseinrichtung (18a, 18b, 18c) abgestrahlten Wellenlängenbereich und das Polarisationsfilter (28) auf die Polarisationsebene oder Polarisationsrichtung der Beleuchtungseinrichtung (18a, 18b, 18c) abgestimmt ist.
